# EUROPEAN PATENT APPLICATION

(11) **EP 4 350 906 A1**
(43) Date of publication of application: **10.04.2024**
(21) Application number: 22811372.6
(22) Date of filing: 26.05.2022
(51) Int. Cl.: H01S 3/11, C04B 35/50, H01S 3/06, H01S 3/16

(54) **Q-SWITCH STRUCTURE AND Q-SWITCH STRUCTURE MANUFACTURING METHOD**

(30) Priority: 28.05.2021 JP 2021090546
(71) Applicant: SHIN-ETSU CHEMICAL CO., LTD., Tokyo 1000005 (JP); NATIONAL UNIVERSITY CORPORATION TOYOHASHI UNIVERSITY OF TECHNOLOGY, Toyohashi-shi, Aichi 441-8580 (JP)
(72) Inventor: WATANABE, Toshiaki, Annaka-shi, Gunma 379-0195 (JP); GOTO, Taichi, Sendai-shi, Miyagi (JP); INOUE, Mitsuteru, Toyohashi-shi, Aichi 441-8580 (JP)
(74) Representative: Mooser, Sebastian Thomas
(86) International application number: PCT/JP2022/021479
(87) International publication number: WO 2022/250102

(57) **Abstract**

The present invention provides a Q-switch structure comprising, a solid-state laser medium, and a magneto-optical material, wherein the solid-state laser medium and the magneto-optical material are joined and integrated. In addition, the solid-state laser medium has a thickness of 1 mm or more, and the solid-state medium and the magneto-optical material are directly joined. Consequently, the Q-switch is applicable to high optical output and contributes to the miniaturization of a laser apparatus.

## Description

### TECHNICAL FIELD

The present invention relates to a Q-switch structure and a method of producing a Q-switch structure.

### BACKGROUND ART

For laser application devices such as optical measurement and magneto-optical recording, a laser medium as a light source has faced a challenge recently in higher output and miniaturization. From the viewpoint of miniaturization and higher output, a Q-switch with a magneto-optical material (also referred to as [MO material]) as a transmitting mechanism attracts attention.

A laser apparatus, in which a first resonant mirror, a solid-state laser material, a Q-switch, and a second resonant mirror are arranged sequentially, is known as the laser apparatus having the Q-switch. Consequently, the laser apparatus is known in which the solid-state laser material and the Q-switch are arranged between a pair of resonant mirrors configured with the first resonant mirror and the second resonant mirror.

Non Patent Document 1 discloses a compact laser apparatus in which a solid-state laser material and a Q-switch are arranged between a pair of resonant mirrors, but the Q-switch is a passive Q-switch utilizing a saturation phenomenon and is uncontrollable actively.

Non Patent Document 2 discloses a technique to control a Q-switch actively utilizing an electro-optical effect. However, a solid-state laser material has a thickness of 0.5 mm, whereas a Q-switch has a thickness of 5 mm, making the Q-switch an obstacle to the miniaturization of the laser apparatus.

Non Patent Document 3 discloses a technique to control a Q-switch actively utilizing an acousto-optical effect, however, the Q-switch has more thickness of 32 mm, and the Q-switch is an obstacle to the miniaturization of a laser apparatus.

In a conventional technique, an actively controllable Q-switch makes the Q-switch larger, consequently, the Q-switch is an obstacle to the miniaturization of a laser apparatus. For that reason, achieving both miniaturizing the laser apparatus and activating the Q-switch is desired.

Patent Document 1 discloses a technique to activate a Q-switch within the restriction that does not interfere with the miniaturization of a laser apparatus. In this apparatus, a solid-state laser material and a Q-switch are arranged between a pair of resonant mirrors and further configure the Q-switch with a combination of a film having a magneto-optic effect and a magnetic flux generator. Furthermore, a Q-switch solid-state laser apparatus emits a pulsed laser, when an excitation light enters a solid-state laser material and a pulse is applied to a magnetic flux generator.

### CITATION LIST

### PATENT LITERATURE

Patent Document 1: JP 2017-79283 A

### NON PATENT LITERATURE

Non Patent Document 1: T.Taira, M.Tsunekane, K.Kanehara, S.Morishima, N.Taguchi and A. Sugiura: "7. Promise of Giant Pulse Micro-Laser for Engine Ignition", Journal of Plasma and Fusion Research, Vol. 89, No.4, pp.238-241(2013)
Non Patent Document 2: T.Taira, and T.Kobayashi: "Q-Switching and Frequency Doubling of Solid-state Lasers by a Single Intracavity KTP Crystal", IEEE Journal of Quantum Electronics of Vol. 30, No.3, pp.800-804(1994)
Non Patent Document 3: Gooch & Housego Co.Ltd., Product number 1-QS041-1, 8C10G-4-GH21

### SUMMARY OF INVENTION

### TECHNICAL PROBLEM

A Q-switch using a magneto-optical (MO) mechanism is described in Patent Document 1 as above-described. Considering a miniaturization of a laser apparatus, a smaller gap between a solid-state laser medium and the magneto-optical mechanism is desired. In FIG. 13 in Patent Document 1, an integrated structure configured with a solid-state laser medium and a magneto-optical film, for example, is proposed. However, a specific integration method is not proposed.

The present invention has been made in view of the above-described problem. An object of the present invention is to provide a Q-switch applicable to high optical output and contributable to the miniaturization of a laser apparatus.

### SOLUTION TO PROBLEM

To achieve the object, the present invention provides a Q-switch structure comprising:
a solid-state laser medium; and
a magneto-optical material, wherein
the solid-state laser medium and the magneto-optical material are joined and integrated;
the solid-state laser medium has a thickness of 1 mm or more; and
the solid-state medium and the magneto-optical material are directly joined.

Such a Q-switch structure has a solid-state laser medium and a magneto-optical material being joined and integrated, consequently, such a structure can be a compact Q-switch structure. In addition, the solid-state laser medium and the magneto-optical material can join directly, thus there is no degradation of performance due to, for example, the deterioration of materials in between, as is the case when materials are used in between. Incidentally, an integrated combination of the solid-state laser medium and the magneto-optical material is referred to as a Q-switch structure in the present invention. The Q-switch structure used in combination with a magnetic flux generator can function as the Q-switch.

Furthermore, in the inventive Q-switch structure, the magneto-optical material is preferably formed by crystal growth on the solid-state laser medium by using the solid-state laser medium as a substrate thereby being joined and integrated with the solid-state laser medium.

A join and integration by such crystal growth can easily form a joined structure configured with the solid-state laser medium and the magneto-optical material.

Moreover, the magneto-optical material is preferably a bismuth-substituted rare earth iron garnet.

Additionally, the solid-state laser medium is preferably selected from any one of ceramics selected from the group comprised of Y₃Al₅O₁₂, Gd₃Ga₅O₁₂, and (GdCa)₃(GaMgZr)₅O₁₂ doped with anyone selected from the group comprised of Nd, Yb, and Cr.

These materials can preferably be used for the inventive Q-switch structure.

Furthermore, the present invention provides a Q-switch solid-state laser apparatus having the Q-switch structure, above described, and a magnetic flux generator arranged between a pair of resonant mirrors.

Such the Q-switch solid-state laser apparatus having the inventive Q-switch structure has a solid-state laser medium and a magneto-optical material being directly joined and thus can be a compact Q-switch structure. In addition, the solid-state laser medium and the magneto-optical material are joined directly, thus there is no degradation of performance due to, for example, the deterioration of materials in between.

Additionally, the present invention provides a method of producing a Q-switch structure comprising a solid-state laser medium and a magneto-optical material in which the solid-state laser medium and the magneto-optical material are joined and integrated, the method comprising the steps of:
preparing the solid-state laser medium having a thickness of 1 mm or more; and
forming the magneto-optical material by crystal growth on the solid-state laser medium by using the solid-state laser medium as a substrate; and
thereby producing the Q-switch structure in which the solid-state laser medium and the magneto-optical material are directly joined and integrated.

Such a method of producing the Q-switch structure can easily perform join and integration between the solid-state laser medium and the magneto-optical material. In addition, the solid-state laser medium and magneto-optical material can join directly in the Q-switch structure being produced, thus there is no degradation of performance due to, for example, the deterioration of materials in between.

In this case, a method for the crystal growth is preferably a liquid phase epitaxial growth method.

Thus, the liquid phase epitaxial growth method can be used to easily join and integrate the solid-state laser medium and the magneto-optical material in the Q-switch structure.

Moreover, the magneto-optical material is preferably a bismuth-substituted rare earth iron garnet.

Furthermore, the solid-state laser medium is preferably selected from any one of ceramics selected from the group comprised of Y₃Al₅O₁₂, Gd₃Ga₅O₁₂, and (GdCa)₃(GaMgZr)₅O₁₂ doped with anyone selected from a group comprised of Nd, Yb, and Cr.

These materials can preferably be used in the inventive method of producing the Q-switch structure.

Additionally, the present invention provides a method of producing a Q-switch solid-state laser apparatus comprising:
producing the Q-switch structure by the method of producing a Q-switch structure; and
producing the Q-switch solid-state laser apparatus by arranging the Q-switch structure and a magnetic flux generator between a pair of resonant mirrors.

Such a method of producing the Q-switch solid-state laser apparatus, in which the solid-state laser medium and the magneto-optical material join directly in the Q-switch structure, can produce the compact Q-switch solid-state laser apparatus. In addition, the solid-state laser medium and magneto-optical material join directly, thus there is no degradation of performance due to, for example, the deterioration of materials in between.

### ADVANTAGEOUS EFFECTS OF INVENTION

An inventive Q-switch structure has a solid-state laser medium and a magneto-optical material being joined and integrated, thus can be a compact Q-switch structure. Moreover, the solid-state laser medium and the magneto-optical material join directly, thus there is no degradation of performance due to, for example, the deterioration of materials in between. Consequently, the structure can meet higher optical output. Moreover, the distance between the solid-state laser medium and the magneto-optical material is 0 because being joined and integrated, thus contributing to the miniaturization of the laser apparatus. Furthermore, such a Q-switch structure can prevent the following flaws: oscillation generated by activation of a magnetic switch (generated by flux change); an optical resonance between the magneto-optical material and the solid-state laser medium; output instability due to changes in magnetic domain pattern caused by distortion due to fixed discrepancy in magneto-optical materials; variation of a switching speed; degradation of the switching speed due to the increase of a resonance wavelength generated by a space between the magneto-optical material and the solid-state laser medium. Hence, the inventive method of producing the Q-switch structure can produce such a Q-switch structure with ease.

### BRIEF DESCRIPTION OF DRAWINGS

FIG. 1 is a schematic diagram illustrating an example of a structure of a Q-switch structure schematically according to the present invention.
FIG. 2 is a cross-sectional view illustrating an example of a structure of a Q-switch structure schematically according to the present invention.
FIG. 3 is a cross-sectional view illustrating an example of a structure of a Q-switch solid-state laser apparatus having a Q-switch structure according to the present invention.
FIG. 4 is a flowchart illustrating an example of a method of producing a Q-switch structure according to the present invention.

### DESCRIPTION OF EMBODIMENTS

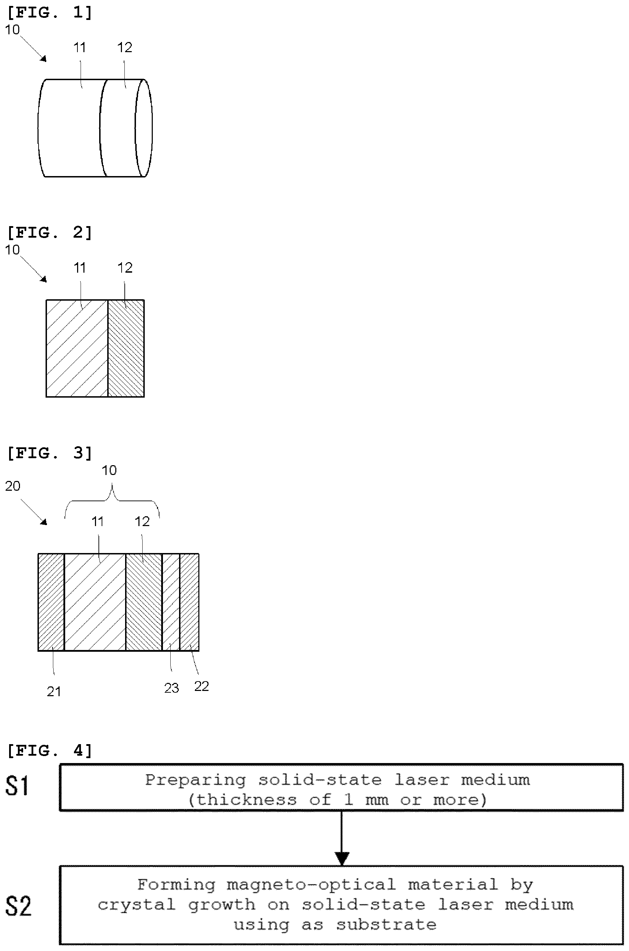

Hereinafter, embodiments of the present invention will be described with reference to the drawings. However, the present invention is not limited thereto. An example of a structure of an inventive Q-switch structure is described with reference to FIG. 1 and FIG. 2. FIG. 1 illustrates a schematic diagram of a structure of a Q-switch structure. FIG. 2 illustrates a cross-sectional view of the structure.

An inventive Q-switch structure 10 includes a solid-state laser medium 11 and a magneto-optical material 12, and the solid-state laser medium 11 and the magneto-optical material 12 are joined and integrated.
Furthermore, the solid-state laser medium 11 has a thickness of 1 mm or more, and the solid-state laser medium 11 and the magneto-optical material 12 are joined directly in the present invention.

More specifically, the magneto-optical material 12 is grown by crystal growth on the solid-state laser medium 11 by using the solid-state laser medium 11 as a substrate for crystal growth. The magneto-optical material 12 is preferably joined and integrated with the solid-state laser medium 11 by crystal growth.

Such a Q-switch structure 10 functions as a Q-switch by combining the magneto-optical material 12 and a magnetic flux generator. FIG. 3 illustrates an example of a structure of a Q-switch solid-state laser apparatus. A Q-switch solid-state laser apparatus 20 arranges the Q-switch structure 10 and a magnetic flux generator 23 between a pair of resonant mirrors (a first resonant mirror 21 and a second resonant mirror 22) as above described. FIG. 3 illustrates an example in which all these structures are joined and integrated. However, in the present invention, only the solid-state laser medium 11 and the magneto-optical material 12 configuring the Q-switch structure 10 need to be joined and integrated, and other materials for the structure can be arranged appropriately. For example, the magnetic flux generator can be a combination of a permanent magnet and an exciting coil, and the exciting coil can be arranged around the permanent magnet.

Materials usable for the solid-state laser mediums can be used for a material for the solid-state laser medium 11 in the inventive Q-switch structure 10. Specifically, considering crystal growth when the solid-state laser medium 11 is used as a substrate, the material is preferably selected from any one of ceramics selected from the group comprised of Y₃Al₅O₁₂, Gd₃Ga₅O₁₂, and (GdCa)₃(GaMgZr)₅O₁₂ doped with anyone selected from a group comprised of Nd, Yb, and Cr. Additionally, materials usable for the magneto-optical materials can be used for material for the magneto-optical material 12 in the inventive Q-switch structure 10. Considering the crystal growth, the magneto-optical material 12 is preferably a bismuth-substituted rare earth iron garnet.

### [Method of producing Q-switch structure]

Then, an inventive method of producing a Q-switch structure is explained. An inventive method of producing a Q-switch structure is a method of producing a Q-switch structure 10 comprising a solid-state laser medium 11 and a magneto-optical material 12, as shown in FIG. 1 and FIG. 2, in which the solid-state laser medium 11 and the magneto-optical material 12 are joined and integrated, the method comprising the steps of:
preparing the solid-state laser medium 11 having a thickness of 1 mm or more; and
forming the magneto-optical material 12 by crystal growth on the solid-state laser medium 11 by using the solid-state laser medium as a substrate; and
thereby producing the Q-switch structure 10 in which the solid-state laser medium 11 and the magneto-optical material 12 are directly joined and integrated.

The inventive method of producing the Q-switch structure is described in detail with reference to FIG. 4. Firstly, as illustrated in S1 in FIG. 4, the solid-state laser medium 11 having a thickness of more than 1 mm is prepared (Step S1). The solid-state laser medium 11 prepared here is used as a substrate for crystal growth, thus needs to have a thickness of more than 1 mm. Materials usable for the solid-state laser mediums can be used for a material for the solid-state laser medium 11. Among them, the material is preferably selected from any one of ceramics selected from the group comprised of Y₃Al₅O₁₂, Gd₃Ga₅O₁₂, and (GdCa)₃(GaMgZr)₅O₁₂ doped with anyone selected from a group comprised of Nd, Yb, and Cr. These yttrium aluminum garnet (YAG), gadolinium gallium garnet (GGG), and CaMgZr substitution type gadolinium gallium garnet (SGGG) are not only excellent for the solid-state laser medium but also particularly preferred when the magneto-optical material 12 is bismuth-substituted rare earth iron garnet as described below.

Then, as illustrated in S2 of FIG. 4, using the solid-state laser medium 11 as a substrate, the magneto-optical material 12 is grown by crystal growth on the solid-state laser medium 11 (step S2). In this case, the crystal growth of the magneto-optical material 12 is preferably performed by the liquid phase epitaxial growth method (LPE). An ordinary method can be adopted as a method for liquid-phase epitaxial growth. For example, this can be done by heating and melting the material of the magneto-optical material 12 in a platinum crucible and then attaching the melt surface of the magneto-optical material 12 to one surface of the solid-state laser medium 11, which is the substrate.

For the material for the magneto-optical material 12, the materials usable in general for the magneto-optical material can be used. Among them, the magneto-optical material 12 is preferably a bismuth-substituted rare earth iron garnet. The bismuth-substituted rare earth iron garnet is excellent as the material for the magneto-optical material 12 configuring the Q-switch. When Yttrium aluminum garnet (YAG), gadolinium gallium garnet (GGG), and CaMgZr substitution type gadolinium gallium garnet (SGGG) are used as described above for the material for the solid-state laser medium 11, which is the substrate for the crystal growth, the bismuth-substituted rare earth iron garnet used for the magneto-optical material 12 makes the crystal growth easier because both of them are the garnets.

Using a Q-switch structure produced by the method of producing the Q-switch structure described above, the Q-switch solid-state laser apparatus can be produced by arranging the Q-switch structure and a magnetic flux between a pair of resonant mirrors.

### EXAMPLE

Hereinafter, the present invention will be specifically described with reference to Examples and Comparative Examples. However, the present invention is not limited thereto.

### [Example 1-1]

As described below, a Q-switch structure 10, illustrated in FIG. 1 and FIG. 2, was produced.

Firstly, a solid-state laser medium 11 (Nd: SGGG) was prepared from CaMgZr substitution type gadolinium gallium garnet (SGGG) doped with Nd (Step S1 in FIG. 4). This solid-state laser medium 11 had a thickness of 1.5 mm and a diameter of 1 inch (25.4 mm) and was used as a substrate material. The solid-state laser medium 11 was used as the substrate for crystal growth.

Secondly, Tb₄O₇, Eu₂O₃, Fe₂O₃, Ga₂O₃, and Bi₂O₃ were introduced into a platinum crucible and melted by heating to a temperature of 1050°C. Then, the temperature of the heat-melted melt was lowered to 850°C. Moreover, the solid-state laser medium 11, which was a substrate for the crystal growth, was attached to a melt surface in the platinum crucible, and grown the 250 um crystal by an LPE method (Step S2 in FIG. 4). Consequently, the magneto-optical material 12 (bismuth-substituted rare earth iron garnet) was grown on the solid-state laser medium 11 by the crystal growth. Then the solid-state laser medium 11 and the magneto-optical material 12 were directly joined and integrated, hence the Q-switch structure 10 was produced.

A crystal surface of the magneto-optical material 12 and a surface of the solid-state laser medium 11, which was the substrate, were optically polished to adjust a Faraday rotation angle to 45 deg when infrared light of 1064 nm wavelength was irradiated.

To evaluate an optical characteristic of the Q-switch structure 10 (an integrated sample of the solid-state laser medium 11 and the magneto-optical material 12), both surfaces (polished surfaces) of the magneto-optical material 12 and the solid-state laser medium 11 were coated with an antireflection film coating for air, and then the evaluation of the optical characteristic was performed. As a result, an insertion loss of 1.1 dB and an extinction ratio of 29 dB was gained. The extinction ratio of less than 30 dB was due to the effect of an interface reflection caused by the refractive index difference between the solid-state laser medium 11 and the magneto-optical material 12. This is within the acceptable range for this material combination.

### [Example 1-2]

A Q-switch structure 10 was produced as in Example 1-1, although a thickness was adjusted by polishing to set a Faraday rotation angle to 22.5 degrees. Then an optical characteristic was evaluated as in Example 1-1, an insertion loss of 0.65 dB and an extinction ratio of 29dB was gained. Although the rotation angle was small, the insertion loss was reduced in the magneto-optical material 12 portions.

### [Example 1-3]

In a Q-switch structure 10 that was produced as in Example 1-1, a Q-switch solid-state laser apparatus 20 was produced by forming a first resonant mirror 21 layer on a surface of a solid-state laser medium 11 and forming a second resonant mirror 22 layer on a surface of a magneto-optical material 12.

### [Example 2-1]

A Q-switch structure 10 was produced as illustrated in FIG. 1 and FIG. 2 as described below.

Firstly, a solid-state laser medium 11 (Nd: GGG) was prepared from gadolinium gallium garnet (GGG) doped with Nd (Step S1 in FIG. 4). This solid-state laser medium 11 had a thickness of 1.5 mm and a diameter of 1 inch (25.4 mm) and was used as a substrate material. The solid-state laser medium 11 was used as the substrate for crystal growth.

Secondly, Tb₄O₇, Yb₂O₃, Fe₂O₃, Al₂O₃, and Bi₂O₃ were introduced into a platinum crucible and melted by heating to a temperature of 1100°C. Then, the temperature of the heat-melted melt was lowered to 850°C. Moreover, the solid-state laser medium 11, which was a substrate for the crystal growth, was attached to a melt surface in the platinum crucible, and grown the 300 um crystal by the LPE method (Step S2 in FIG. 4). Consequently, the magneto-optical material 12 (bismuth-substituted rare earth iron garnet) was grown on the solid-state laser medium 11 by the crystal growth. Then the solid-state laser medium 11 and the magneto-optical material 12 were directly joined and integrated, hence the Q-switch structure 10 was produced.

A crystal surface of the magneto-optical material 12 and a surface of the solid-state laser medium 11, which was the substrate, were optically polished to adjust a Faraday rotation angle to 22.5 deg when infrared light of 1064 nm wavelength was irradiated.

To evaluate an optical characteristic of the Q-switch structure 10 (an integrated sample of the solid-state laser medium 11 and the magneto-optical material 12), both surfaces (polished surfaces) of the magneto-optical material 12 and the solid-state laser medium 11 were coated with an antireflection film coating for air, and then the evaluation of the optical characteristic was performed. As a result, an insertion loss of 0.7 dB and an extinction ratio of 30 dB was gained. The low extinction ratio of 30 dB was due to the effect of an interface reflection caused by the refractive index difference between the solid-state laser medium 11 and the magneto-optical material 12. This is within the acceptable range for this material combination.

### [Example 2-2]

In a Q-switch structure 10 that was produced as in Example 2-1, a Q-switch solid-state laser apparatus 20 was produced by forming a first resonant mirror 21 layer on a surface of a solid-state laser medium 11 and forming a second resonant mirror 22 layer on a surface of a magneto-optical material 12.

### [Example 3-1]

As described below, a Q-switch structure 10, which was illustrated in FIG 1 and FIG. 2, was produced.

Firstly, a solid-state laser medium 11 (Nd: GGG) was prepared from gadolinium gallium garnet (GGG) doped with Nd (Step S1 in FIG. 4). This solid-state laser medium 11 had a thickness of 1.5 mm and a diameter of 1 inch (25.4 mm) and was used as a substrate material. This solid-state laser medium 11 was used as the substrate for crystal growth.

Secondly, Pr₂O₃, Lu₂O₃, Fe₂O₃, Ga₂O₃, and Bi₂O₃ were introduced into a platinum crucible and melted by heating to a temperature of 1100°C. Then, the temperature of the heat-melted melt was lowered to 850°C. Moreover, the solid-state laser medium 11, which was a substrate for the crystal growth, was attached to a melt surface in the platinum crucible and grown the 120 um crystal the by LPE method (Step S2 in FIG. 4). Consequently, the magneto-optical material 12 (bismuth-substituted rare earth iron garnet) was grown on the solid-state laser medium 11 by the crystal growth. Then the solid-state laser medium 11 and the magneto-optical material 12 were directly joined and integrated, hence the Q-switch structure 10 was produced.

A crystal surface of the magneto-optical material 12 and a surface of the solid-state laser medium 11, which was the substrate, were optically polished to adjust a Faraday rotation angle to 7.5 deg when infrared light of 1064 nm wavelength was irradiated.

To evaluate an optical characteristic of the Q-switch structure 10 (an integrated sample of the solid-state laser medium 11 and the magneto-optical material 12), both surfaces (polished surfaces) of the magneto-optical material 12 and the solid-state laser medium 11 were coated with an antireflection film coating for air, and then the evaluation of the optical characteristic was performed. As a result, an insertion loss of 0.6 dB and an extinction ratio of 30 dB was gained.

### [Example 3-2]

In a Q-switch structure 10 that was produced as in Example 3-1, a Q-switch solid-state laser apparatus 20 was produced by forming a first resonant mirror 21 layer on a surface of a solid-state laser medium 11 and forming a second resonant mirror 22 layer on a surface of a magneto-optical material 12.

In compositions used in Example 3-1 and Example 3-2, the magneto-optical material 12 indicated in-plane magnetic anisotropy and steep magnetic hysteresis, therefore low magnetic flux driving is enabled when Q-switch is produced.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A Q-switch structure comprising:
a solid-state laser medium; and
a magneto-optical material, wherein
the solid-state laser medium and the magneto-optical material are joined and integrated;
the solid-state laser medium has a thickness of 1 mm or more; and
the solid-state medium and the magneto-optical material are directly joined.

2. The Q-switch structure according to claim 1, wherein
the magneto-optical material is formed by crystal growth on the solid-state laser medium by using the solid-state laser medium as a substrate thereby joining and integrating with the solid-state laser medium.

3. The Q-switch structure according to claim 1 or 2, wherein
the magneto-optical material is a bismuth-substituted rare earth iron garnet.

4. The Q-switch structure according to any one of claims 1 to 3, wherein
the solid-state laser medium is selected from any one of ceramics selected from the group comprised of Y₃Al₅O₁₂, Gd₃Ga₅O₁₂, and (GdCa)₃(GaMgZr)₅O₁₂ doped with anyone selected from the group comprised of Nd, Yb, and Cr.

5. A Q-switch solid-state laser apparatus comprising:
the Q-switch structure according to any one of claims 1 to 4 and a magnetic flux generator being arranged between a pair of resonant mirrors.

6. A method of producing a Q-switch structure comprising a solid-state laser medium and a magneto-optical material in which the solid-state laser medium and the magneto-optical material are joined and integrated, the method comprising the steps of:
preparing the solid-state laser medium having a thickness of 1 mm or more; and
forming the magneto-optical material by crystal growth on the solid-state laser medium by using the solid-state laser medium as a substrate; and
thereby producing the Q-switch structure in which the solid-state laser medium and the magneto-optical material are directly joined and integrated.

7. The method of producing the Q-switch structure according to claim 6, wherein
a method for the crystal growth is a liquid phase epitaxial growth method.

8. The method of producing the Q-switch structure according to claim 6 or 7, wherein
the magneto-optical material is a bismuth-substituted rare earth iron garnet.

9. The method of producing the Q-switch structure according to claims any one of 6 to 8, wherein
the solid-state laser medium is selected from any one of ceramics selected from the group comprised of Y₃Al₅O₁₂, Gd₃Ga₅O₁₂, and (GdCa)₃(GaMgZr)₅O₁₂ doped with anyone selected from a group comprised of Nd, Yb, and Cr.

10. A method of producing a Q-switch solid-state laser apparatus comprising:
producing the Q-switch structure by the method of producing a Q-switch structure according to any one of claims 6 to 9; and
producing the Q-switch solid-state laser apparatus by arranging the Q-switch structure and a magnetic flux generator between a pair of resonant mirrors.
